# EUROPÄISCHE PATENTSCHRIFT

(11) **EP 1 547 166 B1**
(45) Veröffentlichungstag und Bekanntmachung des Hinweises auf die Patenterteilung: **04.03.2015**
(21) Anmeldenummer: 03773459.7
(22) Anmeldetag: 24.09.2003
(51) Int. Cl.: H01L 33/00, H05B 33/00

(54) **LICHTQUELLENMODUL SOWIE VERFAHREN ZU DESSEN HERSTELLUNG**
LIGHT SOURCE MODULE AND METHOD FOR PRODUCTION THEREOF
MODULE DE SOURCES DE LUMIERE ET PROCEDE DE FABRICATION

(30) Priorität: 30.09.2002 DE 10245945
(43) Veröffentlichungstag der Anmeldung: 29.06.2005
(73) Patentinhaber: OSRAM Opto Semiconductors GmbH, 93055 Regensburg (DE)
(72) Erfinder: KROMOTIS, Patrick, 93051 Regensburg (DE); WAITL, Günter, 93049 Regensburg (DE)
(74) Vertreter: Epping - Hermann - Fischer
(86) Internationale Anmeldenummer: PCT/DE2003/003189
(87) Internationale Veröffentlichungsnummer: WO 2004/032571

(56) Entgegenhaltungen:
- US-A- 4 935 665
- PATENT ABSTRACTS OF JAPAN Bd. 2000, Nr. 20, 10. Juli 2001 (2001-07-10) & JP 2001 085748 A (MATSUSHITA ELECTRIC WORKS LTD), 30. März 2001 (2001-03-30)
- PATENT ABSTRACTS OF JAPAN Bd. 0184, Nr. 47 (E-1594), 19. August 1994 (1994-08-19) & JP 6 140673 A (NIPPON TELEGR & TELEPH CORP <NTT>), 20. Mai 1994 (1994-05-20)

## Beschreibung

Die Erfindung betrifft ein Lichtquellemodul mit mehreren LEDs (LED = light emitting device), die isolierend mit einem Metallträger verbunden sind.

Ein derartiges Lichtquellenmodul ist z.B. in der Offenlegungsschrift DE 100 51 159 A1 beschrieben.

Die Druckschrift JP 2001-085748 A beschreibt ein Licht emittierendes Bauteil.

Aus der noch nicht veröffentlichten deutschen Anmeldung mit der Anmeldungsnummer 102 29 067 ist z.B. bekannt, eine LED in einem Rahmen anzuordnen und den Bereich zwischen Rahmen und LED mit Vergußmasse auszugießen. Um einen Reflektor zu erhalten, wird vorzugsweise zuerst reflektierende Vergußmasse in dem Bereich zwischen Rahmen und LED eingefüllt und anschließend mit klarer Vergußmasse komplett vergossen.

Diese Art der Herstellung eines Lichtquellenmoduls funktioniert problemlos, wenn nur eine LED innerhalb des Rahmens angeordnet ist.

Sind jedoch mehrere LEDs in einem Rahmen angeordnet, ist der Rahmen durch die Vergußmasse komplett mit dem Metallträger, auf welchem die LEDs über eine Isolierschicht angeordnet sind, flächig verbunden.

Bei stark unterschiedlichen Temperaturbelastungen dehnt sich der Metallträger unterschiedlich zum Rahmen aus, da der Rahmen in der Regel nicht aus Metall besteht und somit die beiden Werkstoffe unterschiedliche Ausdehnungskoeffizienten aufweisen.

Durch die unterschiedlichen Ausdehnungskoeffizienten dieser beiden Bauteile kommt es zu Belastungen auf die LEDs, was somit Ausfälle einzelner LEDs bzw. so zur Zerstörung des gesamten Lichtquellenmoduls führen kann.

Der Erfindung liegt daher die Aufgabe zugrunde, ein Lichtquellenmodul aufzuzeigen, welches auch stark wechselnden Temperaturbedingungen Stand hält.

Diese Aufgabe wird erfindungsgemäß dadurch gelöst, daß die LEDs von einem Rahmen umgeben sind, zwischen Rahmen und LEDs Vergußmasse angeordnet ist und der Rahmen Dehnfugen aufweist.

Durch das Einbringen der Dehnfugen in den Rahmen ist es möglich, die aus der nachveröffentlichten Patentanmeldung 102 29 067 bekannte Technologie zu verwenden, einen Rahmen auf die LEDs aufzusetzen und den Zwischenraum mit Vergußmasse auszugießen.

Die Dehnfugen können entweder über extrem dünn gehaltene Stellen im Rahmen realisiert sein, die sich bei einer Ausdehnung verformen können bzw. auch über Schlitze, die komplett durch den Rahmen hindurchgehen.

Gemäß einer bevorzugten Ausführungsform ist der Rahmen in mehrere Rahmenteile durch Dehnfugen segmentiert.

Hierbei weist ein Rahmenteil vorzugsweise maximal vier Aussparungen auf, in denen LEDs angeordnet werden können. Diese Anzahl von Aussparungen pro Rahmenteil garantiert bei einer Herstellung des Rahmens aus Kunststoff und des Metallträgers aus Aluminium auch bei hohen Temperaturschwankungen eine hohe Zuverlässigkeit und Funktionsfähigkeit.

Die LEDs sind im Lichtquellenmodul vorzugsweise im Raster z.B. im Raster von 4,5 mm in 8 Spalten und 4 Reihen angeordnet und können zur Realisierung einer LED-Lichtquelle für ein HUD-System (HUD = Head-Up Display) in einem Kraftfahrzeug verwendet werden.

Die Segmentierung des Rahmens zur Herstellung des Lichtquellenmoduls erfolgt vorzugsweise am Ende der Prozeßkette, d.h. nach Einbringung in der Vergußmasse. Dies kann z.B. mittels einer Sägevorrichtung geschehen.

Weitere Vorteile der Erfindung sind in den Unteransprüchen sowie der nachfolgenden Figurenbeschreibung offenbart.

In den Zeichnungen zeigen:
- Figur 1: ein Teil des erfindungsgemäßen Lichtquellenmoduls in Schnittansicht,
- Figur 2: einen Rahmen für das Lichtquellenmodul in der Ansicht von oben,
- Figur 3: den Schnitt A-A aus Figur 2,
- Figur 4a und 4b: den Rahmen für das Lichtquellenmodul in der Ansicht von oben und in Seitenansicht,
- Figur 5a und 5b: einen Träger mit aufgebrachter Leiterplatte für das Lichtquellenmodul in der Ansicht von oben sowie Seitenansicht und
- Figur 6a und 6b: den Rahmen aus den Figuren 4a und 4b sowie den Träger mit aufgebrachter Leiterplatte aus den Figuren 5a und 5b im montierten Zustand.

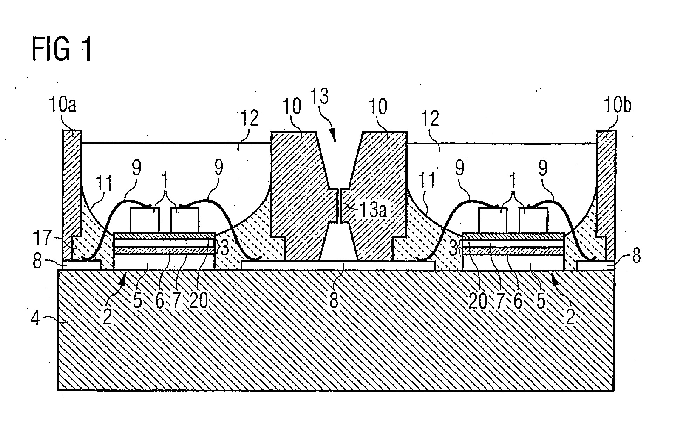

Figur 1 zeigt ein LED-Lichtquellenmodul in teilweiser Schnittansicht.

Das Lichtquellenmodul weist im dargestellten Ausschnitt zwei LEDs auf, wobei eine LED jeweils zwei auf einem Trägersubstrat 2 angeordnete optoelektronische Bauelemente 1 umfaßt.

Das Trägersubstrat 2 besteht in der Regel aus einem gut wärmeleitendem Material und ist jeweils über eine zwischengeschaltete Isolierschicht 3 sowie einer Trägerschicht 5 auf einem Metallträger 4 angeordnet, der nicht nur als Träger, sondern auch als Kühlkörper dient. Der Metallträger 4 besteht vorzugsweise aus Aluminium oder Kupfer, um eine hohe Wärmeableitung zu erhalten.

Die im Trägersubstrat 2 integrierte Isolierschicht 3 besteht in der Regel aus einer Siliziumoxidschicht 6 und einer auf der Siliziumoxidschicht 6 aufgebrachten Siliziumnitridschicht 7. Die Siliziumoxidschicht ist auf einer Trägerschicht 5 aus Siliziumsubstrat aufgebracht. Die isolierende Wirkung wird insbesondere durch die Siliziumnitrid- und Siliziumoxidschicht 7 und 6 erzielt, wobei das Siliziumsubstrat 5 im wesentlichen nur als Trägermaterial dient. Auf der isolierenden Schicht 7 befinden sich leitfähige Metallpads 20 zur Kontaktierung der LED.

Da Siliziumschichten extrem dünn aufgebracht werden können und eine gute Wärmeleitfähigkeit aufweisen, sind diese Schichten ideal für die elektrische Isolierung und die Wärmeabführung von den optoelektronischen Bauelementen 1 über die Trägersubstrate 2 zum Metallträger 4.

Zwischen den Trägersubstraten 2 sind weitere Leiterplatten 8 angeordnet, welche zur elektrischen Verbindung der optoelektronischen Bauelemente 1 untereinander dienen. Für die Verbindung zwischen den Leiterplattenplatten 8 und den optoelektronischen Bauelementen 1 ist eine Verdrahtung 9 vorgesehen.

Um die LEDs vergießen zu können und auch zur Herstellung eines Reflektors ist auf das Lichtquellenmodul ein Rahmen 10 aufgesetzt, welcher jeweils einen Trägersubstrat 2 mit aufgesetzten optoelektronischen Bauelementen 1 umschließt.

Der Rahmen 10 ist an der Unterseite mit den Leiterplatten 8 verklebt, so daß die Zwischenräume, in denen sich die LEDs befinden, ausgegossen werden können.

Um einen Reflektor zu erzielen, wird zuerst der Rahmen mit reflektierender Vergußmasse 11, wie z.B. weißes Silikon oder einer Füllmasse mit Titanoxid (TiO₂) oder auch einem mit Titanoxidpartikeln versetzten Epoxidharz vergossen.

Der Verguß erfolgt bis knapp unter die Oberkante des Trägersubstrats 2, wobei die Oberfläche der reflektierenden Vergußmasse 11 konkav zum Innenrand des Rahmens 10 verläuft.

Im zweiten Schritt erfolgt ein Verguß des Innenraums mit klarer Vergußmasse 12, wobei hierzu in der Regel transparentes Silikon oder transparentes Epoxidharz verwendet wird.

Durch den Verguß des Rahmens 10 mit der reflektierenden klaren Vergußmasse 11 und 12 ist dieser mehr oder weniger fest mit den LEDs verbunden.

Der Rahmen 10 wird aus Kostengründen in der Regel aus Kunststoff hergestellt, so daß sich bei starken Temperaturunterschieden große Belastungen bzgl. der LEDs ergeben, da sich der Kunststoffrahmen 10 unterschiedlich ausdehnt, wie der in der Regel aus Aluminium bestehende Metallträger 4.

Um diese mechanischen Belastungen auf die LEDs abzufangen, sind im Rahmen 10 Dehnfugen 13 vorgesehen, über welche die stark temperaturabhängige Ausdehnung des Metallträgers 4 aus Aluminium abgefangen werden kann. Die Dehnfugen 13 können als stark verjüngte Stelle im Rahmen 10 ausgebildet sein, so daß sich an dieser stark verjüngten Stelle der Kunststoff des Rahmens 10 bei auftretenden Belastungen elastisch verformen kann.

Ebenso können die Dehnfugen 13, wie in Figur 1 dargestellt, auch als komplette Trennung des Rahmens 10 an dieser Stelle ausgebildet sein. Bei der kompletten Trennung des Rahmens 10 ist in der Regel in der Dehnfuge 13 ein Trennschnitt 14 vorgehen, so daß separate Rahmenteile 10a und 10b entstehen.

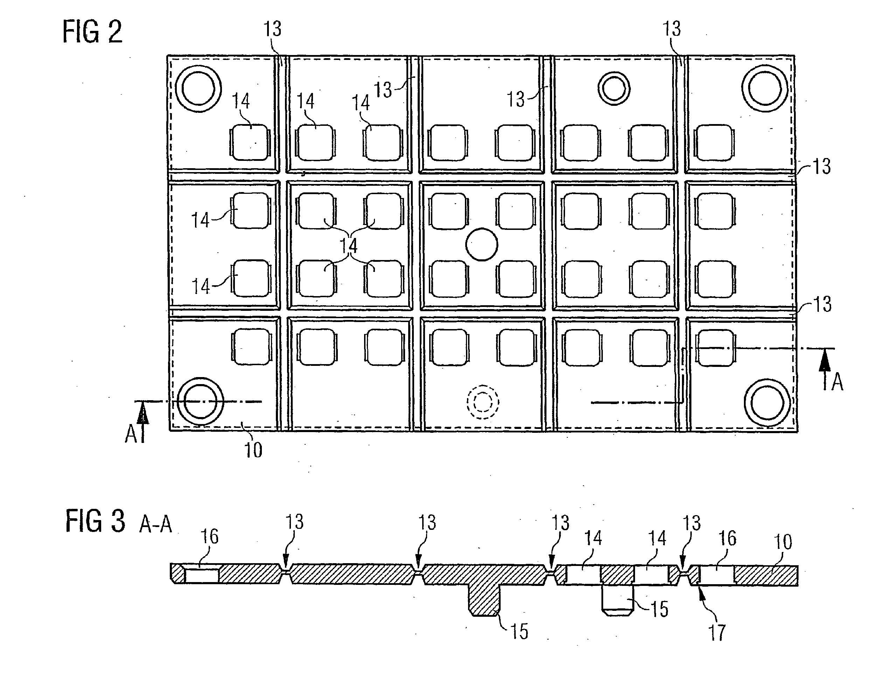

Figur 2 zeigt in einer Ansicht von oben den kompletten Rahmen 10, wie er z.B. für ein Lichtquellenmodul für ein Head-Up Displaysystem (HUD-System) in einem Kraftfahrzeug verwendet wird.

Der Rahmen 10 weist zweiunddreisig Aussparungen 14 auf, in welchen jeweils ein Trägersubstrat 2 mit zumindest zwei optoelektronischen Bauelementen 1, wie in Figur 1 dargestellt, angeordnet sind.

Für das Head-up Displaysystem sind hierzu die Lichtpunkte in einem Raster von 4,5 mm in 8 Spalten und 4 Reihen angeordnet. Polychrome Lichtpunkte werden dadurch erhalten, daß mehrere optoelektronischen Bauelemente 1 mit unterschiedlicher Farbe auf einem Trägersubstrat 2 angeordnet werden.

Um die mögliche Beschädigung der LEDs durch starke Temperaturschwankungen und den daraus resultierenden unterschiedlichen Ausdehnungen des Rahmens 10 und des Metallträgers 4 zu vermeiden, sind in dem Rahmen 10 die Dehnfugen 13 gitterförmig angeordnet, so daß der Rahmen in mehrere Segmente durch die gitterförmigen Dehnfugen 13 unterteilt ist. Ein Rahmensegment umfaßt hierbei maximal vier Aussparungen 14.

Figur 3 zeigt den Schnitt A-A aus Figur 1 durch den Rahmen 10. Der Rahmen 10 ist im wesentlichen flächig ausgebildet und weist an seiner Unterseite Zapfen 15 auf, mit welchen er auf den Metallträger 4 montiert werden kann. Desweiteren sind ebenso Montagebohrungen 16 vorgesehen, welche ebenso zur Verbringung mit dem Metallträger herangezogen werden können.

Im rechten Teil des in Figur 3 dargestellten Schnittes sind die Aussparungen 14 im Querschnitt dargestellt, wobei diese an der Unterseite kleine Hinterschneidungen 17 aufweisen, so daß die reflektierende Vergußmasse 11 auch formschlüssig aufgenommen ist.

An den Stellen der Dehnfugen 13 weist der Rahmen beidseitig eine trapezförmige Aussparung auf, welche entweder so gewählt werden kann, daß bereits der dünne Steg die Verformung aufnimmt oder, wie in Figur 1 dargestellt, an dieser Stelle mittels einer Sägevorrichtung der verbleibende Steg mit einem Trennschnitt 14 durchtrennt wird.

Die Durchtrennung kann nach abgeschlossener Montage des Rahmens auf den Metallträger 4 sowie dem Verguß der Aussparungen 14 erfolgen.

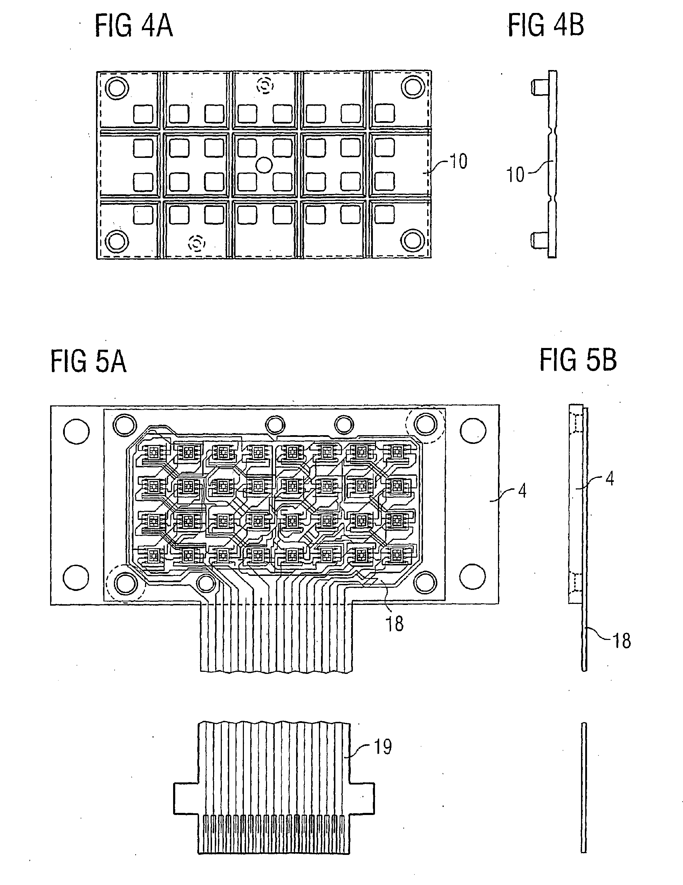

In den Figuren 4 bis 6 ist kurz schematisch die Montage des Rahmens 10 dargestellt. Die Figuren 4a bis 6a zeigen jeweils die Ansicht von oben, Figur 4b bis 6b die Seitenansicht.

Die Figuren 4a und 4b zeigen die in den Figuren 2 und 3 beschriebenen Rahmen, die Figuren 5a und 5b zeigen den Metallträger 4 mit aufgebrachter Isolier- und Trägerschicht sowie einer darauf angeordnete flexible Leiterplatte 18 mit einem Flexleiteranschluß 19, wobei auf der flexiblen Leiterplatte 18 die Trägersubstrate 2 sowie die optoelektronischen Bauelemente 1 aufgebracht sind.

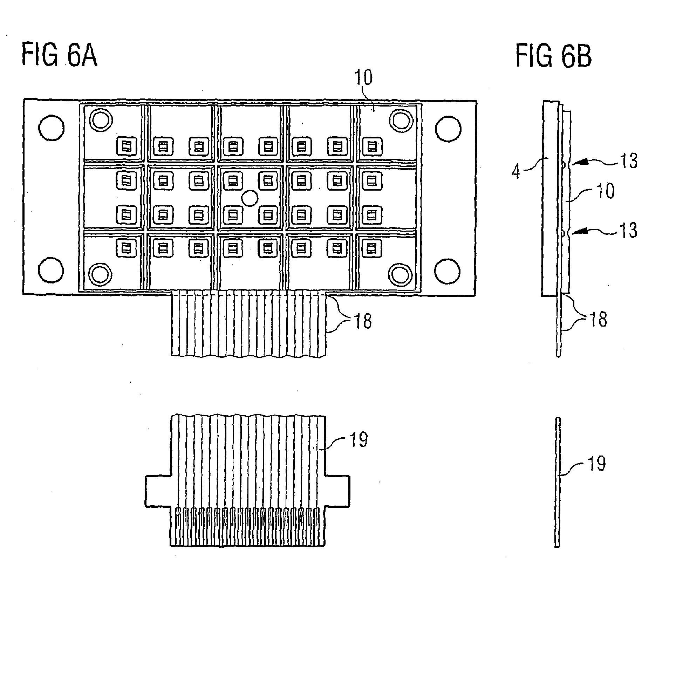

Die Figuren 6a und 6b zeigen wie der Rahmen 10 lediglich auf den Metallträger 4 mit der bereits aufgebrachten flexiblen Leiterplatte 18 aufgesteckt und mit dieser verklebt wird.

Das Durchtrennen der Dehnfugen 13 mit der Sägevorrichtung kann bereits nach diesem Verfahrensschritt oder auch erst nach dem Vergießen der Aussparungen 14 erfolgen.

Der Schutzumfang der Erfindung ist nicht durch die Beschreibung der Erfindung anhand der Ausführungsbeispiele beschränkt. Vielmehr umfasst die Erfindung jedes neue Merkmal sowie jede Kombination von Merkmalen, was insbesondere jede Kombination von Merkmalen in den Patentansprüchen beinhaltet, auch wenn diese Kombination nicht explizit in den Patentansprüchen angegeben ist.

## Patentansprüche

1. Lichtquellenmodul mit mehreren LEDs, die isolierend mit einem Metallträger (4) verbunden sind,
wobei die LEDs von einem Rahmen (10) umgeben sind, zwischen dem Rahmen (10) und den LEDs Vergußmasse (11, 12) angeordnet ist und der Rahmen (10) Dehnfugen (13) aufweist.

2. Lichtquellenmodul nach Anspruch 1,
wobei der Rahmen (10) in mehrere Rahmenteile (10a, 10b) durch Dehnfugen segmentiert ist.

3. Lichtquellenmodul nach einem der Ansprüche 1 oder 2,
wobei pro Rahmenteil maximal vier Aussparungen (14) für die Aufnahme von LEDs vorgesehen sind.

4. Lichtquellenmodul nach einem der Ansprüche 1 bis 3,
wobei der Rahmen (10) aus Kunststoff hergestellt ist.

5. Lichtquellenmodul nach einem der Ansprüche 1 bis 4,
wobei der Rahmen (10) an der Unterseite zu einer Leiterplatte (8) hin verklebt ist.

6. Lichtquellenmodul nach einem der Ansprüche 1 bis 5,
wobei der Metallträger (4) aus Aluminium oder Kupfer hergestellt ist.

7. Lichtquellenmodul nach einem der Ansprüche 1 bis 6,
wobei die LEDs im Raster angeordnet sind.

8. Verfahren zur Herstellung eines Lichtquellenmoduls nach einem der Ansprüche 2 bis 7,
wobei die Segmentierung des Rahmens (10) mit einer Sägevorrichtung durchgeführt wird, so daß zwischen den Rahmenteilen Trennschnitte (14) entstehen.

## Claims

1. Light source module having a plurality of LEDs connected to a metal carrier (4) in an insulating manner, wherein the LEDs are surrounded by a frame (10), potting composition (11, 12) is arranged between the frame (10) and the LEDs and the frame (10) has expansion joints (13).

2. Light source module according to Claim 1,
wherein the frame (10) is segmented into a plurality of frame parts (10a, 10b) by expansion joints.

3. Light source module according to either of Claims 1 and 2,
wherein a maximum of four cutouts (14) for receiving LEDs are provided per frame part.

4. Light source module according to one of Claims 1 to 3,
wherein the frame (10) is produced from plastic.

5. Light source module according to one of Claims 1 to 4,
wherein the frame (10) is adhesively bonded at the underside toward the printed circuit board (8).

6. Light source module according to one of Claims 1 to 5,
wherein the metal carrier (4) is produced from aluminum or copper.

7. Light source module according to one of Claims 1 to 6,
wherein the LEDs are arranged in a grid.

8. Method for producing a light source module according to one of Claims 2 to 7,
wherein the segmentation of the frame (10) is carried out by means of a sawing device, so that separating cuts (14) arise between the frame parts.

## Revendications

1. Module de source de lumière présentant plusieurs LED raccordés de manière isolée à un support métallique (4),
les LED étant entourées par un cadre (10),
une pâte de coulée (11, 12) étant disposée entre le cadre (10) et les LED et le cadre (10) présentant des joints de dilatation (13).

2. Module de source de lumière selon la revendication 1, dans lequel le cadre (10) est segmenté en plusieurs parties (10a, 10b) de cadre par des joints de dilatation.

3. Module de source de lumière selon l'une des revendications 1 ou 2, dans lequel pour chaque partie de cadre, au plus quatre découpes (14) sont prévues pour la reprise de LED.

4. Module de source de lumière selon l'une des revendications 1 à 3, dans lequel le cadre (10) est réalisé en matière synthétique.

5. Module de source de lumière selon l'une des revendications 1 à 4, dans lequel le cadre (10) est collé sur une carte de circuit (8) sur son côté inférieur.

6. Module de source de lumière selon l'une des revendications 1 à 5, dans lequel le support métallique (4) est réalisé en aluminium ou en cuivre.

7. Module de source de lumière selon l'une des revendications 1 à 6, dans lequel les LED sont disposés en trame.

8. Procédé de fabrication d'un module de source de lumière selon l'une des revendications 2 à 7, dans lequel la segmentation du cadre (10) est réalisée avec un dispositif de sciage de telle sorte que des découpes de séparation (14) soient formées entre les parties de cadre.
